(19) Europäisches Patentamt

European Patent Office

Office européen des brevets

(11) **EP 0 863 224 A1**

(12) **EUROPÄISCHE PATENTANMELDUNG**

(43) Veröffentlichungstag:
**09.09.1998 Patentblatt 1998/37**

(51) Int. Cl.$^6$: **C23C 14/24**

(21) Anmeldenummer: **98104006.6**

(22) Anmeldetag: **06.03.1998**

(84) Benannte Vertragsstaaten:
**AT BE CH DE DK ES FI FR GB GR IT LI LU MC NL PT SE**
Benannte Erstreckungsstaaten:
**AL LT LV MK RO SI**

(30) Priorität: **06.03.1997 DE 19709218**
**14.08.1997 DE 19735352**

(71) Anmelder:
**Elektroschmelzwerk Kempten GmbH**
**81737 München (DE)**

(72) Erfinder:
• **Bencker, Ulrich**
**87439 Kempten (DE)**

• **Lerf, Siegfried**
**87477 Sulzberg (DE)**
• **Seifert, Martin**
**78437 Kempten (DE)**
• **Wörle, Peter**
**87435 Kempten (DE)**
• **Jüngling, Thomas, Dr.**
**87487 Wiggensbach (DE)**
• **Müller, Stefan**
**87487 Wiggensbach (DE)**

(74) Vertreter: **Potten, Holger et al**
**Wacker-Chemie GmbH**
**Zentralabteilung Patente,**
**Marken und Lizenzen**
**Hanns-Seidel-Platz 4**
**81737 München (DE)**

(54) **Keramischer Verdampfer mit einer Verjüngung der Verdampferenden**

(57) Die Erfindung betrifft einen keramischen Verdampfer zum Beschichten von flexiblen Substraten mit Metallen, dadurch gekennnzeichnet, daß die Enden des Verdampfers derart verjüngt sind, daß bedingt durch die Verjüngung im Betrieb ein definiertes Temperaturprofil auf der Verdampferoberfläche erhalten wird, welches ein Vordringen des zu verdampfenden Metalls bis zu den Enden des Verdampfers verhindert.

Fig. 1

## Beschreibung

Die Erfindung betrifft einen keramischen Verdampfer mit einer Verjüngung der Verdampferenden.

Das gebräuchlichste Verfahren zum Beschichten von flexiblen Substraten mit Metallen, insbesondere mit Aluminium, ist die sog. Hochvakuum-Bandbedampfung. Das zu beschichtende Substrat wird über eine gekühlte Walze geführt und dabei dem Aluminiumdampf ausgesetzt, der sich auf der Substratoberfläche als dünne Metallschicht niederschlägt.

Zur Erzeugung des erforderlichen konstanten Dampfstromes werden keramische Verdampfer im direkten Stromdurchgang auf etwa 1450°C erhitzt. Aluminiumdraht wird kontinuierlich zugeführt, auf der Keramikoberfläche verflüssigt und bei einem Vakuum von ca. $10^{-4}$ mbar verdampft.

In Metallisierungsanlagen sind eine Reihe von Verdampfern so angeordnet, daß sich über die gesamte Breite des Substratbandes eine gleichmäßig dicke Aluminiumschicht niederschlägt.

Die Halterung der Verdampfer erfolgt durch gekühlte Kupferspannbacken, wobei sowohl eine sog. stirnseitige als auch eine sog. seitliche Einspannung möglich ist.

Die Breite und Länge des Verdampfers werden entsprechend der erforderlichen Abdampfrate (g Al min$^{-1}$) gewählt. Die übliche Form von Verdampfern geht von einem rechteckigen Querschnitt aus. Der rechteckige Querschnitt hat sich bewährt, weil er eine hohe mechanische Stabilität, auch bei hohen Temperaturen, und eine kostengünstige Fertigung ermöglicht. Außerdem können rechteckige Verdampfer sowohl in seitlichen als auch in stirnseitigen Einspannsystemen verwendet werden.

Neben Verdampfern mit rechteckigem Querschnitt sind auch solche mit nicht rechteckigem Querschnitt beschrieben worden.

US 4.089.643 beschreibt Verdampfer mit Dreiecksquerschnitt und Kavität. Als wesentliche Vorteile gegenüber einem rechteckigen Querschnitt werden die Materialeinsparung und die reduzierte elektrische Leistung zum Betreiben eines solchen Verdampfers genannt.

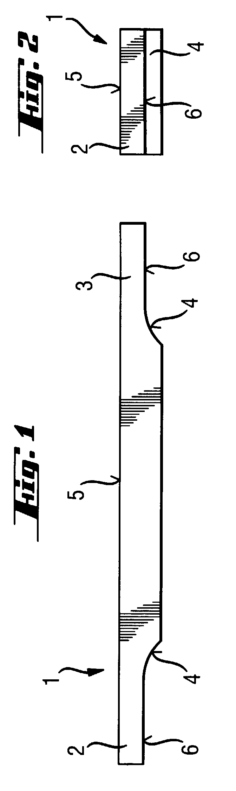

US 3.181.968 zeigt in Fig. 1 einen Verdampfer mit reduzierter Verdampferbreite und konstanter Verdampferdicke. Das Patent betrifft für Verdampfer geeignete Materialzusammensetzungen. Aussagen zur Formgebung des Verdampfers und deren Folgen finden sich nicht.

Ausgehend von der Geometrie des Verdampfers und den elektrischen Eigenschaften des Keramikmaterials (charakterisiert durch den spezifischen Widerstand $R_{spec}$) läßt sich der Ohm'sche Widerstand R des Verdampfers im elektrischen Stromkreis nach Gleichung (1) berechnen.

$$R = R_{spec} \times L/A \qquad (1)$$

L: Länge des Verdampfers
A: leitfähiger Querschnitt

Der Verdampfer verhält sich im Stromkreis wie ein metallischer Widerstand, d.h. sein Widerstand nimmt mit steigender Temperatur zu. Für die genaue Charakterisierung der elektrischen Eigenschaften ist daher zusätzlich die Kenntnis des Verhältnisses zwischen Widerstand bei Betriebstemperatur und Raumtemperatur notwendig. Für keramische Verdampfer liegt das Verhältnis $R_{HT}/R_{RT}$ zwischen 2,3 - 6,0.

Verdampfer für Bandbedampfungsanlagen sind so dimensioniert, daß für rechteckige Querschnitte üblicherweise spezifische Widerstände bei Raumtemperatur von 100 - 1500 $\mu\Omega$cm gewählt werden können.

Für diesen Widerstandsbereich ergibt sich die chemische Zusammensetzung der Verdampfer zu

45 - 55 Gew.% TiB$_2$
25 - 55 Gew.% BN
0 - 20 Gew.% AlN

Solche Zusammensetzungen sind u.a. in den Patenten (z.B. US-A-3,915,900 oder die in US-A-4,089,643, Spalte 1, Zeilen 10 und 11 bzw. Spalte 2, Zeile 5 zitierten Patente) beschrieben.

In der Regel werden Verdampfer von den Herstellern der Metallisierungsanlagen im Bereich +/- 50 $\mu\Omega$cm spezifiziert. Die Einstellung des geforderten Widerstandsbereiches erfolgt durch Variation des Verhältnisses leitender (TiB$_2$) und nicht leitender Phase (BN + AlN).

Weitere Eigenschaften, z.B.

- die Korrosionsbeständigkeit gegenüber Aluminium
- die gute Benetzbarkeit der Keramikoberfläche durch flüssiges Aluminium

werden ebenfalls durch die chemische Zusammensetzung des Verdampfers bestimmt.

Um eine stabile Verdampfung und damit eine gleichmäßige Schichtdicke zu erreichen, muß das System Verdampfer/Aluminiumbad regelbar sein. Dies muß auch bei hohen Abdampfraten - wie sie derzeit nur mit keramischen Verdampfern erreicht werden können - gewährleistet sein.

Zum Erzielen hoher Ohm'scher Widerstände muß bei vorgegebener Verdampfergeometrie der TiB$_2$-Gehalt reduziert werden. Dies hat zur Folge, daß sowohl das anfängliche Benetzungsverhalten als auch das Einregeln auf einen stabilen Verdampfungszustand erschwert werden.

Ein Problem im Betrieb heute bekannter Verdampfer besteht darin, daß Aluminium, welches von der Oberfläche des Verdampfers verdampft wird, bis zu den Enden des Verdampfers, mit welchen der Verdampfer in einer Verdampfereinspannung befestigt ist, gelangen kann, wodurch die Verdampfereinspannung beschädigt oder sogar zerstört werden kann.

Aufgabe der Erfindung war es, keramische Verdampfer zum Beschichten von flexiblen Substraten mit Metallen zur Verfügung zu stellen, bei denen das vorgenannte Problem minimiert ist.

Die Erfindung betrifft einen Verdampfer, der dadurch gekennzeichnet ist, daß seine Enden derart verjüngt sind, daß bedingt durch die Verjüngung im Betrieb ein definiertes Temperaturprofil auf der Verdampferoberfläche erhalten wird, welches das Vordringen des zu verdampfenden Metalls bis zu den Enden des Verdampfers verhindert.

Es hat sich gezeigt, daß durch eine gezielte Querschnittsverjüngung an den Verdampferenden definierte Temperaturprofile auf der Verdampferoberfläche eingestellt werden können.

Die Verjüngung der Verdampferenden führt dort zu einer höheren Stromdichte. Dadurch kommt es in diesem Bereich zu einer höheren Temperatur, die bewirkt, daß Aluminium verstärkt abdampft. Dadurch wird vermieden, daß flüssiges Aluminium bis zur Einspannung läuft und diese beschädigt oder zerstört.

Vorzugsweise erfolgt die Verjüngung der Verdampferenden durch eine Reduktion der Verdampferdicke während die Verdampferbreite in der Regel konstant bleibt. Ein solcher Verdampfer 1 ist beispielhaft in Fig. 1 (Seitenansicht) und Fig. 2 (Stirnansicht) dargestellt.

Die Verjüngung der Verdampferenden 2, 3 kann linear oder nicht linear erfolgen. So ist es beispielsweise möglich, die Verjüngung der Verdampferenden durch Einarbeiten eines Radius 4 zu realisieren. Auch dies ist beispielhaft in Fig. 1 dargestellt.

Vorzugsweise erfolgt die Verjüngung der Verdampferenden derart, daß die Verdampferober- und -unterseite 5, 6 am Verdampferende 2, 3 planparallel bleiben. Auch dies ist beispielhaft in Fig. 1 und 2 dargestellt.

Vorzugsweise beträgt die Verjüngung der Dicke der Verdampferenden 5 bis 60% der maximalen Dicke des Verdampfers.

Besonders bevorzugt liegt die Verjüngung der Dicke der Verdampferenden zwischen 20 und 50% der maximalen Dicke des Verdampfers.

Vorzugsweise beträgt die Verjüngung an beiden Verdampferenden jeweils maximal 30% der Verdampferlänge.

Besonders bevorzugt beträgt die Verjüngung an beiden Verdampferenden jeweils 10 bis 20% der Verdampferlänge.

In die erfindungsgemäßen Verdampfer kann eine Kavität eingearbeitet sein. Es ist jedoch ebenso möglich, diese Verdampfer mit einer planen Oberfläche, d.h. ohne Kavität zu betreiben.

Die erfindungsgemäßen Verdampfer lassen sich in herkömmlichen Bedampfungsanlagen, wie sie im Stand der Technik bekannt sind, in üblicher Art und Weise betreiben.

**Patentansprüche**

1. Keramischer Verdampfer zum Beschichten von flexiblen Substraten mit Metallen, dadurch gekennnzeichnet, daß die Enden des Verdampfers derart verjüngt sind, daß bedingt durch die Verjüngung im Betrieb ein definiertes Temperaturprofil auf der Verdampferoberfläche erhalten wird, welches ein Vordringen des zu verdampfenden Metalls bis zu den Enden des Verdampfers verhindert.

2. Verdampfer nach Anspruch 1, dadurch gekennzeichnet, daß die Verjüngung der Enden des Verdampfers durch eine Reduktion der Verdampferdicke erfolgt ist.

3. Verdampfer nach Anspruch 1 oder 2, dadurch gekennzeichnet, daß die Verjüngung der Enden des Verdampfers durch Einarbeiten eines Radius realisiert ist.

4. Verdampfer nach Anspruch 1, 2 oder 3, dadurch gekennzeichnet, daß Verdampferober- und -unterseite am Verdampferende planparallel sind.

5. Verdampfer nach einem der Ansprüche 1 bis 4, dadurch gekennzeichnet, daß die Verjüngung der Dicke der Verdampferenden 5 bis 60% der maximalen Dicke des Verdampfers beträgt.

6. Verdampfer nach Anspruch 5, dadurch gekennzeichnet, daß die Verjüngung der Dicke der Verdampferenden 20 bis 50% der maximalen Dicke des Verdampfers beträgt.

7. Verdampfer nach einem der Ansprüche 1 bis 6, dadurch gekennzeichnet, daß die Verjüngung an beiden Verdampferenden jeweils maximal 30% der Verdampferlänge beträgt.

8. Verdampfer nach Anspruch 7, dadurch gekennzeichnet, daß die Verjüngung an beiden Verdampferenden jeweils 10 bis 20% der Verdampferlänge beträgt.

9. Verdampfer nach einem der Ansprüche 1 bis 8, dadurch gekennzeichnet, daß in die Verdampferoberfläche eine Kavität eingearbeitet ist.

10. Verdampfer nach einem der Ansprüche 1 bis 8, dadurch gekennzeichnet, daß die Verdampferoberfläche plan ist.

Fig. 2

Fig. 1

Europäisches
Patentamt

## EUROPÄISCHER RECHERCHENBERICHT

Nummer der Anmeldung

EP 98 10 4006

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | GB 2 109 416 A (STANDARD TELEPHONES CABLES LTD) 2.Juni 1983<br>* Seite 1, Zeile 87 - Zeile 116; Abbildung 1 *<br>--- | 1-4,10 | C23C14/24 |
| X | US 4 112 290 A (NAKAJIMA YUKIHIKO ET AL) 5.September 1978<br>* Spalte 2, Zeile 24 - Zeile 49 *<br>--- | 1,2,4,9 | |
| A | DE 22 03 638 A (SIEMENS AG) 2.August 1973<br>* Seite 3, Zeile 21 - Zeile 34 *<br>----- | 1-10 | |

RECHERCHIERTE SACHGEBIETE (Int.Cl.6)

C23C

Der vorliegende Recherchenbericht wurde für alle Patentansprüche erstellt

| Recherchenort | Abschlußdatum der Recherche | Prüfer |
|---|---|---|
| DEN HAAG | 26.Juni 1998 | Ekhult, H |

EPO FORM 1503 03.82 (P04C03)